Europäisches Patentamt

European Patent Office

Office européen des brevets

(11) Numéro de publication: **0 384 834 A1**

## (12) DEMANDE DE BREVET EUROPEEN

(21) Numéro de dépôt: **90400467.8**

(22) Date de dépôt: **21.02.90**

(51) Int. Cl.⁵: **H01L 21/48, C04B 41/88**

(30) Priorité: **22.02.89 FR 8902279**

(43) Date de publication de la demande:
**29.08.90 Bulletin 90/35**

(84) Etats contractants désignés:
**AT BE CH DE ES FR GB GR IT LI LU NL SE**

(71) Demandeur: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07(FR)**

(72) Inventeur: **Rotman, Frédéric**
**Teisan K.K. 9-1 Chinonome 1-chome**
**Koto-ku, Tokyo 135(JP)**
Inventeur: **Rançon, Yannick**
**36, rue de Villacoublay**
**F-78140 Velizy(FR)**
Inventeur: **Queille, Philippe**
**7, rue Rieussec**
**F-78220 Viroflay(FR)**
Inventeur: **Olivier, Michel**
**19 rue du Roussillon, Val des Quatre Pignons**
**F-78650 Beynes(FR)**

(74) Mandataire: **Le Moenner, Gabriel et al**
**L'AIR LIQUIDE, Société Anonyme pour l'etude et l'exploitation des procédés Georges Claude 75, Quai d'Orsay**
**F-75321 Paris Cédex 07(FR)**

(54) **Procédé de métallisation de céramiques et appareil pour sa mise en oeuvre.**

㊼ Métallisation de céramiques du genre où l'on dépose une pâte métallique à base de molybdène et/ou tungstène et de manganèse sur un substrat céramique et où l'on assure le frittage de ladite pâte dans une atmosphère à potentiel d'oxydo-réduction prédéterminé, avec montée et maintien à une température comprise entre 1.300°C et 1.600°C, puis refroidissement jusqu'à la température ambiante, avec réalisation d'une atmosphère par adjonction à un gaz neutre pur (13) d'une quantité d'oxygène d'appoint (15) et d'une quantité d'hydrogène (14) au moins suffisante pour obtenir ensuite par réaction catalytique la teneur désirée en vapeur d'eau et le cas échéant la teneur excédentaire en hydrogène.

Fig.1

La présente invention concerne la métallisation de céramiques du genre où l'on dépose une pâte métallique à base de molybdène et/ou de tungstène, et de manganèse sur un substrat céramique notamment de l'alumine, et en ce qu'on assure ensuite un frittage de ladite pâte métallique dans une atmosphère à potentiel d'oxydo-réduction prédéterminée, avec montée et maintien à une température comprise entre 1300°C et 1600°C, puis refroidissement jusqu'à la température ambiante.

La métallisation de céramiques trouve sa principale application dans le domaine de l'industrie électrotechnique. Le métal est utilisé pour ses propriétés conductrices, tandis que la céramique joue le rôle de support mécanique, de barrière thermique, ou d'isolant électrique.

La liaison entre la céramique et le métal passe par une première étape de métallisation de la céramique, suivie d'une étape de nickelage et enfin d'un brasage du métal utile sur cette céramique métallisée et nickelée.

La métallisation de la céramique consiste en un frittage à haute température d'une pâte à base de molybdène et/ou de tungstène et de manganèse. L'objectif est d'éliminer les liants organiques qui confèrent à la pâte sa rhéologie puis d'oxyder le manganèse tout en restant réducteur vis à vis du molybdène et du tungstène. Cette opération de frittage s'effectue sous atmosphère à potentiel d'oxydo-réduction contrôlé. Les atmosphères les plus couramment utilisées sont l'ammoniac craqué humide, l'hydrogène humide, ou un mélange d'hydrogène, d'azote et de vapeur d'eau. Les conditions de frittage ont été étudiées par M.E. ARTHUR et L.F. FUSSEL dans un article "Effect of Sintering conditions ou $Al_2O_3$-MoMn bond strengths" paru dans "Ceramic Bulletin", volume 50, n° 12, 1971.

Les atmosphères de traitement qui entrent en jeu dans ces opérations de métallisation doivent avoir des teneurs en vapeur d'eau bien déterminées puisque ces teneurs en vapeur d'eau interviennent aussi bien en tant que telles, qu'en relation dans un rapport avec la teneur en hydrogène, de façon à conférer au gaz un effet oxydant, un effet réducteur, un effet neutre.

L'obtention des atmosphères humides pour ces métallisations de céramiques est actuellement assurée par simple barbotage du gaz dans un récipient contenant de l'eau. Cependant, cette façon de faire présente les inconvénients d'imposer un point de rosée à peu près égal à la température ambiante, et des fluctuations du point de rosée par variation de la température ambiante et du niveau d'eau dans le barboteur. Pour obtenir des points de rosée supérieurs à la température ambiante, on doit alors chauffer l'eau du barboteur si l'on veut, au contraire, obtenir des points de rosée inférieurs à la température ambiante, on doit refroidir l'eau du barboteur ou diluer le gaz saturé en eau par un gaz sec. D'autre part pour obtenir un point de rosée bien fixé, on doit actuellement non seulement réguler la température de l'eau du barboteur, donc mettre en oeuvre des bains thermiquement isolés et thermostatés, mais on doit également réguler le niveau d'eau, donc mettre en oeuvre une sonde de niveau couplée à un dispositif automatique de remplissage. Un agencement de ce type s'avère coûteux, mais en outre, malgré tous ces perfectionnements, il subsiste encore différents inconvénients :

- d'une part la valeur du point de rosée engendrée est fonction de la géométrie du barboteur (en particulier de la surface d'échange eau/gaz), d'où l'obligation de déterminer par étalonnage les conditions opératoires de chaque barboteur (chauffage et dilution) afin d'obtenir les points de rosée désirés.

- d'autre part, dans le cas où l'on désire changer de point de rosée pour passer à un point de rosée supérieur, ce changement obtenu par chauffage du bain présente l'inconvénient d'avoir un temps de réponse long.

- enfin, dans le cas où l'on désire passer à un point de rosée inférieur, le refroidissement du bain présente le même inconvénient d'inertie thermique que ci-dessus, tandis que la dilution présente l'inconvénient d'un changement du débit total lors du passage d'un point de rosée à l'autre.

Ce inconvénients peuvent certes être écartés par une extension quasi-infinie de la surface d'échange eau/gaz par traversée, par example, d'un grand volume de matière poreuse comme décrit dans l'article intitulé "Advanced gas Moisturizing System for Ceramic processing applications" par F. W. GIACOBBE, paru dans "American Ceramic Society Bulletin", Volume 66 N°10, 1987. et par conservation du débit total par réajustement des débits de gaz humidifié et de gaz sec.

Cependant, un tel dispositif d'humidification reste encore peu souple. Sa réalisation est très onéreuse et le problème de l'inertie thermique, dans le cas où l'on désire changer la température du bain, n'est toujours pas résolu.

La présente invention a pour objet de disposer d'un matériel à fonctions plus performantes qui soit simple, souple et peu onéreux. En outre, elle permet de répondre à l'attente de procédés nécessitant des atmosphères à points de rosée à la fois contrôlés et évolutifs, particulièrement nécessaires dans la technique de métallisation de céramiques.

Le procédé de métallisation de céramiques selon l'invention est caractérisé en ce que l'atmosphère de traitement comprend de l'hydrogène et de la vapeur d'eau, le cas échéant un gaz inerte tel l'azote, avec :

- soit un rapport de la teneur en hydrogène à la teneur en eau, dont la valeur est comprise, tout au long du cycle d'élaboration, entre 9 et 36, et avec une teneur en vapeur d'eau comprise entre 0,5 et 5 % et 5 % ;
- soit un rapport de la teneur en hydrogène à la teneur en eau variable au cours du cycle d'élaboration, avec une première phase d'élimination des liants lors de la montée en température jusqu'à errviron 600° C durant laquelle la teneur en vapeur d'eau est comprise entre 2 % et 8 % et le rapport de la teneur en hydrogène à la teneur en vapeur d'eau est compris entre 5 et 20 ; puis une deuxième phase d'oxydation du manganèse lors de la montée en température entre environ 600° C et environ 1000° C, durant laquelle la teneur en vapeur d'eau est comprise entre 0,5 % et 5 % et le rapport de la teneur en hydrogène à la teneur en vapeur d'eau est compris entre 7 et 28 ; puis une troisième phase de frittage et refroidissement jusqu'à la fin du cycle, durant laquelle la teneur en vapeur d'eau est inférieure à 0,1 % et la teneur en hydrogène supérieure à 7 % ;
avec, en outre, réalisation de l'une ou l'autre des dites atmosphères par mélange d'hydrogène et d'une quantité d'oxygène d'appoint, le cas échéant d'un gaz neutre tel l'azote, l'hydrogène étant en quantité au moins suffisante pour obtenir ensuite par réaction catalytique la teneur désirée en vapeur d'eau et le cas échéant la teneur excédentaire en hydrogène qui correspondent à la composition de l'atmosphère requise.

La demanderesse a bien conscience que le principe intrinsèque de réalisation par catalyse d'une teneur en vapeur d'eau dans un gaz a déjà été proposé, notamment dans l'article intitulé "Réduction d'oxyde de fer par hydrogène pur" par L. GUILLET, M. EUDIER et Ph. POUPEAU paru dans "Mémoires Scientifiques Revue Métallurgique" n° 7/8 1967 où l'on propose d'employer, dans une étude de réduction de protoxyde de fer, soit de l'hydrogène pur, soit des mélanges d'hydrogène, de vapeur d'eau et d'argon.

Cependant, la Damanderesse constate que, malgré la connaissance largement répandue de la réaction chimique concernée et de la possibilité de la réaliser par réaction catalytique, aucune application à échelle industrielle à la métallisation des céramiques n'a été proposée à ce jour, malgré les difficultés d'obtention de telles atmosphères humides selon les techniques rappelées ci-dessus et malgré l'effet particulièrement attractif de la solution appliquée, selon L'invention, dans la technique en question, où la reproductibilité et la précision des conditions opératoires de fabrication sont primordiales, et malgré les avantages d'une variation optimale de la teneur en vapeur d'eau en cours de l'opération de métallisation.

Le catalyseur utilisé dans le procédé selon l'invention est choisi de façon à permettre une réaction immédiate et complète de l'oxygène et cela à température ambiante, avec une teneur résiduelle en oxygène inférieure à 10 vpm. Un catalyseur qui peut être utilisé est du type palladium sur support d'alumine qui peut traiter un débit horaire jusqu'à environ 5 000 à 10 000 fois le volume de réacteur. Ce type de catalyseur ne nécessite généralement aucun chauffage préalable du gaz et en outre n'implique pas une séquence de démarrage du réacteur avec rejet initial de gaz à l'air libre.

Selon une autre variante de mise en oeuvre, l'oxygène d'appoint est initialement présent dans l'azote qui est de l'azote brut obtenu par séparation d'air par perméation ou adsorption.

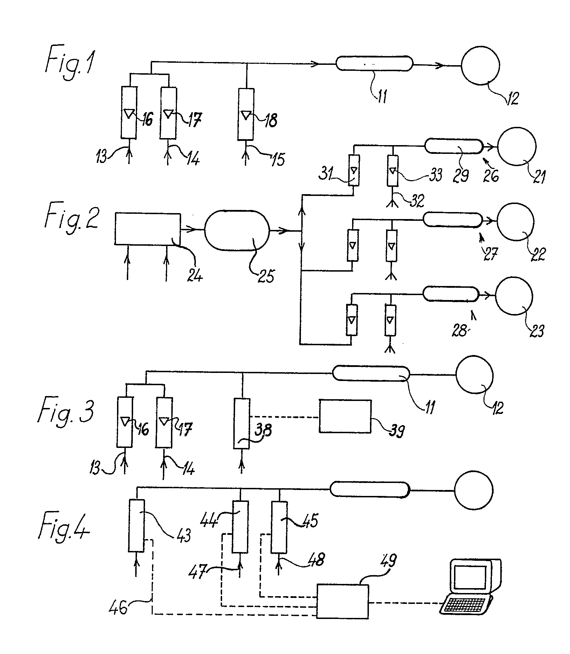

Les caractéristiques et avantages de l'invention ressortiront d'ailleurs de la description qui suit, à titre d'exemples, en référence aux figures 1 à 4 qui représentent schématiquement quatre formes de réalisation de l'invention.

La figure 1 représente une forme de mise en oeuvre simplifiée où les trois constituants gazeux azote ($N_2$), hydrogène($H_2$), oxygène ($O_2$) sont acheminés vers une chambre catalytique 11 et de là vers un four 12 via des conduites d'apport 13 pour l'azote, 14 pour l'hydrogène, 15 pour l'oxygène, chaque conduite 13, 14 et 15 incorporant un débitmètre à flotteur 16-17-18 équipé d'une vanne de réglage qui permet d'ajuster le débit. On assure ainsi, par un simple réglage des débits, une facile mise en oeuvre de points de rosée supérieurs ou inférieurs à la température ambiante.

Selon la figure 2 qui concerne une alimentation commune pour plusieurs fours 21, 22, 23, ... un prémélange d'azote ($N_2$), d'hydrogène ($H_2$), est d'abord réalisé dans un mélangeur 24 pour ensuite être acheminé vers plusieurs postes d'utilisation après passage dans une capacité-tampon commune 25. Chaque ligne de distribution 26, 27, 28, ... comprend :
- un débitmètre 31 pour le réglage du débit du mélange d'azote ($N_2$) et d'hydrogène ($H_2$) ;
- une conduite d'apport 32 à un débitmètre 33 pour le réglage du débit d'oxygène ($O_2$) ;
- une chambre catalytique 29 pour la génération de la vapeur d'eau.

On assure ainsi l'alimentation de plusieurs fours en parallèle et l'on peut, pour un mélange $N_2/H_2$ donné, mettre en oeuvre des points de rosée différents d'un four à l'autre.

Selon la figure 3 qui est une variante de la figure 1, où les mêmes éléments sont désignés par les mêmes chiffres de référence, on assure une plus grande stabilité du point de rosée par l'obtention d'un débit d'oxygène particulièrement stable, ce qui est atteint avec un appareil du type régulateur de débit massique 38 équipé d'une commande 39.

Selon la figure 4, on emploie trois régulateurs de débit massique 43, 44 et 45 dans les conduites d'azote 46, d'hydrogène 47 et d'oxygène 48, couplés à un dispositif 49 à commande informatique, permettant un pilotage dynamique du point de rosée par le biais d'un pilotage automatique des débits. On peut ainsi aisément programmer un profil de point de rosée simultanément avec un profil thermique tout en conservant un débit gazeux total constant.

On peut bien entendu envisager toute combinaison de ces différentes mises en oeuvre.

On donne maintenant ci-après quelques exemples d'application de mise en oeuvre d'atmosphère appliquées à la métallisation de céramiques.

PREMIER EXAMPLE :

Afin de métalliser de l'alumine par la technique molybdène-manganèse par frittage à 1400° C, on met en oeuvre le dispositif selon la figure 3.

Cette version avec régulateur de débit massique sur l'oxygène (précision égale à 1 % de la pleine échelle) est recommandée dans ce cas, car la teneur en vapeur d'eau du mélange injecté dans le four est un paramètre critique pour le frittage de la poudre métallique.

Les débitmètres à flotteur utilisés pour l'azote et l'hydrogène ont une précision égale à 2 % de leur pleine échelle. Le régulateur de débit massique et les débitmètres à flotteur sont choisis de telle sorte que les débits mesurés se situent environ à mi-échelle.

L'objectif est d'injecter dans le four, durant toute la durée du cycle de température, 2 m³/h d'une atmosphère $N_2$, $H_2$, $H_2O$ comprenant 25 % d'hydrogène et 1,2 % de vapeur d'eau.

Le rapport $H_2/H_2O$ (21) est suffisant pour permettre une oxydation du manganèse tout en restant réducteur vis à vis du molybdène.

Cette atmosphère est obtenue à partir d'un mélange primaire de 1476 l/h d'azote et 524 l/h d'hydrogène. La composition des 2000 l/h de ce mélange primaire est donc

$N_2$ = 73,8 % ± 1,5 %
$H_2$ = 26,2 % ± 1,5 %

Une mesure d'humidité sur ce mélange révèle une teneur en vapeur d'eau inférieure à 10 ppm (point de rosée < - 60° C).

On ajoute à ce premier mélange un débit d'oxygène de 12 l/h. Ce débit étant mesuré par un régulateur de débit massique, la précision est de ± 0.24 l/h.

Par passage dans la chambre catalytique, tout l'oxygène réagit avec l'hydrogène en excès pour former de l'eau.

Les valeurs attendues des débits gazeux à la sortie de la chambre catalytique sont les suivantes :

1476 l/h d'azote
500 l/h d'hydrogène
24 l/h de vapeur d'eau
soit un total de 2000 l/h.

Ce résultat permet d'illustrer l'un des avantages de l'invention : quelque soit la teneur en vapeur d'eau désirée, le débit total reste constant (2000 l/h dans ce cas).

Compte tenu des incertitudes sur les débits gazeux, les proportions calculées relatives des constituants gazeux sont les suivantes :

$N_2$ = 73,8 % ± 1,6 %
$H_2$ = 25,0 % ± 1,5 %
$H_2O$ = 1,20 % ± 0,07 %
$O_2$ = 0 %

Un piquage de contrôle en sortie du système catalytique a permis d'analyser le mélange gazeux afin de contrôler la teneur des différents constituants : la teneur en hydrogène est mesurée par un chromatographe, la teneur en vapeur d'eau par un hygromètre à miroir refroidi, tandis que la teneur en oxygène est mesurée par un analyseur à cellule électrolytique.

$H_2$ = 24,4 % ± 0,2 %
$H_2O$ = 1,15 % ± 0,02 %
$O_2$ < 5 ppm

Compte tenu des incertitudes expérimentales, les teneurs mesurées sont tout à fait conformes aux teneurs calculées. Par conséquent, aucun étalonnage n'est nécessaire.

D'autre part, l'emploi d'un régulateur de débit massique sur l'oxygène permet de contrôler facilement la stabilité du point de rosée.

DEUXIEME EXAMPLE

Afin de métalliser de l'alumine par la technique molybdène-manganèse, par frittage à 1400° C, on met en oeuvre le dispositif selon la figure 4.

L'objectif est de générer un point de rosée évolutif en fonction du cycle de température :

(a) de la température ambiante à 550° C :
$H_2O$ = 3 %
$H_2$ = 25 %

(b) de 550° C à 1000° C : $H_2O$ = 2 %
$H_2$ = 25 %

(c) de 1000° C à la fin du cycle $H_2O$ = 0 %
$H_2$ = 10 %

La configuration du matériel selon la figure 4 permet d'engendrer facilement une telle séquence, grâce au pilotage des trois régulateurs de débit massique par ordinateur.

Partie (a) du cycle :

La teneur élevée en vapeur d'eau facilite l'élimination des liants tout en prévenant l'oxydation de manganèse. Les régulateurs de débit massique sont réglés de telle sorte qu'au mélange primaire :

$N_2$ = 72,0 % ± 0,8 % ; $H_2O$ < 10 ppm

$H_2$ = 28,0 % ± 0,8 %

on ajoute un courant d'oxygène égal à

$O_2$ = 1,50 % ± 0,03 % (en pourcentage du débit $N_2$ + $H_2$)

pour obtenir après passage dans la chambre catalytique le mélange suivant (proportions calculées)

$N_2$ = 72,0 % ± 0,9 %

$H_2$ = 25,0 % ± 0,8 %

$H_2O$ = 3,0 % ± 0,12 %

$O_2$ = 0 %

Or les proportions mesurées expérimentalement sont :

$H_2$ = 25,5 % ± 0,2 %

$H_2O$ = 2,97 % ± 0,04 %

$O_2$ < 5 ppm

Compte tenu des incertitudes expérimentales, les teneurs mesurées sont tout à fait conformes aux teneurs calculées.

Partie (b) du cycle :

Lorsque la température dans le four atteint 550°C, de nouveaux débits sont affichés sur les régulateurs de débit massique. Le rapport $H_2/H_2O$-(12,5) est suffisant pour permettre une oxydation du manganèse tout en restant réducteur vis à vis du molybdène.

On rajoute au mélange primaire :

$N_2$ = 73,0 % ± 0,8 %

$H_2$ = 27,0 % ± 0,8 %

$H_2O$ < 10 ppm

un courant d'oxygène

$O_2$ = 1,0 % ± 0,02 % (en pourcentage du débit $N_2$ + $H_2$)

afin d'obtenir, après passage dans la chambre catalytique : (teneurs calculées)

$N_2$ = 73,0 % ± 0,9 %

$H_2$ = 25,0 % ± 0,8 %

$H_2O$ = 2,0 % ± 0,08 %

$O_2$ = 0 %

or les proportions mesurées expérimentalement sont :

$H_2$ = 24,9 % ± 0,2 %

$H_2O$ = 1,91 % ± 0,03 %

$O_2$ < 5 ppm

Partie (c) du cycle :

Lorsque la température dans le four atteint 1000°C, de nouveaux débits sont affichés sur les générateurs de débit massique.

Le courant d'oxygène est ramené à zéro car l'étape d'oxydation du manganèse est terminée.

La proportion d'hydrogène est ramenée à 10 % par souci d'économie.

D'où les proportions calculées :

$N_2$ = 90 % ± 0,4 %

$H_2$ = 10 % ± 0,4 %

$H_2O$ = 0 %

$O_2$ = 0 %

1 minute après basculement de (b) à (c) (T = 1009°C) les teneurs mesurées sont :

$H_2$ = 9,9 % ± 0,1 %

$H_2O$ = 400 ppm ± 20 ppm (point de rosée égal à environ - 30°C)

$O_2$ < 5 ppm

3 minutes après basculement de (b) à (c) (T = 1031°C) les teneurs mesurées sont :

$H_2$ = 9,9 % ± 0,1 %

$H_2O$ < 20 ppm (point de rosée < - 55°C)

$O_2$ < ppm

Le petit rédiduel de vapeur d'eau pendant quelques minutes après l'arrêt du débit d'oxygène correspond à la purge de la chambre catalytique.

Le résiduel étant extrêmement faible au bout d'une minute, la transition est quasi-instantanée.

Cet exemple permet d'illustrer quelques avantages de l'invention :

- pilotage dynamique du point de rosée

- temps de réponse très court en cas de changement de point de rosée.

**Revendications**

1. Procédé de métallisation de cérsmiques, du genre où l'on dépose une pâte métallique à base de molybdène et/ou de tungstène, et de manganèse sur un substrat céramique notamment de l'alumine, et en ce qu'on assure ensuite un frittage de ladite pâte métallique dans une atmosphère à potentiel d'oxydo-réduction prédéterminé, avec montée et maintien à une température comprise entre 1300°C et 1600°C, puis refroidissement jusqu'à la température ambiante, caractérisé en ce que ladite atmosphère de traitement comprend de l'hydrogène et de la vapeur d'eau, le cas échéant un gaz inerte tel l'azote, avec :

- soit un rapport de la teneur en hydrogène à la teneur en eau, dont la valeur est comprise, tout au long du cycle d'élaboration, entre 9 et 36, avec une teneur en vapeur d'eau comprise entre 0,5 % et 5 % ;

- soit un rapport de la teneur en hydrogène à la teneur en eau variable au cours du cycle d'élaboration, avec une première phase d'élimination des liants lors de la montée en température jusqu'à environ 600°C durant laquelle la teneur en vapeur d'eau est comprise entre 2 % et 8 % et le rapport de la teneur en hydrogène à la teneur en vapeur d'eau est compris entre 5 et 20 ; puis une deuxième phase d'oxydation du manganèse lors de la montée en température entre environ 600°C et environ 1000°C, durant laquelle la teneur en vapeur d'eau est comprise entre 0,5 % et 5 % et le rapport de la teneur en hydrogène à la teneur en vapeur d'eau est compris entre 7 et 28 ; puis une troisième phase de frittage puis refroidissement, durant laquelle la teneur en vapeur d'eau est inférieure à 0,1 % et la teneur en hydrogène supérieure à 7 % ;

avec, en outre, réalisation de l'une ou l'autre des dites atmosphères par un mélange d'hydrogène et d'une quantité d'oxygène d'appoint, le cas échéant d'un gaz neutre tel l'azote, l'hydrogène étant en quantité au moins suffisante pour obtenir ensuite par réaction catalytique la teneur désirée en vapeur d'eau et le cas échéant la teneur excédentaire en hydrogène qui correspondent à la composition de l'atmosphère requise.

2. Procédé de métallisation de céramiques selon la revendication 1, caractérisé en ce que l'oxygène d'appoint est initialement présent dans l'azote, qui est de l'azote brut obtenu par séparation d'air par adsorption ou perméation.

3. Procédé de métallisation de céramiques, selon la revendication 1 ou 2, caractérisé en ce que le catalyseur est du type à autonomie énergétique, notamment à palladium sur support d'alumine.

4. Procédé de métallisation de céramiques selon la revendication 1 ou 2, caractérisé en ce que, dans le cas de teneur en vapeur d'eau inférieure à 1 %, le catalyseur est associé à un moyen de chauffage.

5. Appareil pour la mise en oeuvre du procédé selon l'une quelconque des revendications 1 à 4, caractérisé en ce qu'il comprend une conduite de mélange, raccordée à l'amont à au moins deux conduites, le cas échéant à trois conduites d'apport, chacune à commande de débit, et à l'aval à un réacteur catalytique.

6. Appareil selon la revendication 5, caractérisé en ce que la conduite de mélange incorpore un mélangeur raccordé à l'amont à au moins deux conduites individuelles.

7. Appareil selon l'une des revendications 5 ou 6, caractérisé en ce que la conduite de mélange se subdivise, en aval de la communication avec deux conduites d'apport, en une pluralité de conduites individuelles de mélange, dans chacune desquelles débouche la troisième conduite d'apport et qui sont raccordées chacune à un réacteur catalytique individuel.

8. Appareil selon l'une des revendications 5, 6 ou 7, caractérisé en ce qu'un régulateur de débit massique est incorporé à une ou plusieurs conduites d'apport à commande de débit.

Fig.1

Fig.2

Fig.3

Fig.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | SOLID STATE TECHNOLOGY, vol. 28, no. 4, april 1985, pages 321-324, Chemical Inc.; E.A. HAYDUK, Jr.: "Effect of atmosphere composition on metallizing A12O3 substrates with Mo-Mn paste" * Colonne 3, ligne 18 - colonne 4, ligne 17; colonne 5, lignes 19-33 * | 1,3 | H 01 L   21/48 C 04 B   41/88 |
| D,Y | MEMOIRES SCIENTIFIQUES DE LA REVUE DE METALLURGIE, vol. LXIV, nos. 7/8, 1967, pages 654-661; L. GUILLET et al.: "Réduction d'oxyde de fer par l'hydrogène pur" * Colonne 2, ligne 1 - colonne 3, ligne 51; colonne 16, lignes 31-37 * | 1,3 | |
| A | IDEM | 8 | |
| A | FR-A-2 027 125  (R.C.A. CORP.) * Revendications 1,2; page 9, ligne 28 - page 10, ligne 1 * | 1 | |
| A | EP-A-0 209 065  (DAINIPPON SCREEN MFG. CO. LTD) * Résumé; page 2, ligne 32 - page 3, linge 19; page 4, ligne 31 - page 6, ligne 35 * | 1,3-6 | **DOMAINES TECHNIQUES RECHERCHES (Int. Cl.5)** H 01 L   21 C 04 B   41 C 23 C    8 |
| D,A | AMERICAN CERAMIC SOCIETY BULLETIN, vol. 66, no. 10, 1987, pages 1510-1512, ACerS; F.W. GIACOBBE: "Advanced gas moisturizing system for ceramic processing applications" * Colonne 2, ligne 15 - colonne 3, ligne 16; figure 1 * --- -/- | 5-7 | |

Le présent rapport a été établi pour toutes les revendications

| Lieu de la recherche | Date d'achèvement de la recherche | Examinateur |
|---|---|---|
| LA HAYE | 12-04-1990 | OLSSON S.A. |

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-1 337 121 (SIEMENS & HALSKE)<br>* Page 2, ligne 110 - page 3, ligne 25; revendication 1 *<br>----- | 1 | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| LA HAYE | 12-04-1990 | OLSSON S.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................
& : membre de la même famille, document correspondant

EPO FORM 1503 03.82 (P0402)